# EUROPEAN PATENT SPECIFICATION

(11) **EP 4 542 244 B1**
(45) Date of publication and mention of the grant of the patent: **07.10.2026**
(21) Application number: 22947708.8
(22) Date of filing: 17.11.2022
(51) Int. Cl.: G01R 31/3842, G01R 31/396, G01R 31/3828

(54) **SOC CALCULATION METHOD, CONTROL CIRCUIT AND ELECTRONIC DEVICE**
SOC-BERECHNUNGSVERFAHREN, STEUERSCHALTUNG UND ELEKTRONISCHE VORRICHTUNG
PROCÉDÉ DE CALCUL DE SOC, CIRCUIT DE COMMANDE ET DISPOSITIF ÉLECTRONIQUE

(30) Priority: 21.06.2022 CN 202210706862
(43) Date of publication of application: 23.04.2025
(73) Proprietor: EcoFlow Inc., Shenzhen, Guangdong 518000 (CN)
(72) Inventor: ZHAN, Juncheng, Shenzhen, Guangdong 518000 (CN); CHEN, Xi, Shenzhen, Guangdong 518000 (CN)
(74) Representative: Appelt, Christian W.
(86) International application number: PCT/CN2022/132655
(87) International publication number: WO 2023/245973

(56) References cited:
- CN-A- 111 289 902
- CN-A- 111 337 839
- CN-A- 111 913 111
- CN-A- 112 014 751
- CN-A- 112 909 362
- CN-A- 113 300 436
- CN-A- 115 166 542
- JP-A- 2000 014 019
- JP-A- 2020 092 593
- US-A1- 2014 167 656

## Description

### CROSS-REFERENCE TO RELATED APPLICATIONS

This application claims priority to Chinese Patent Application No. 202210706862.0, entitled "SOC CALCULATION METHOD, CONTROL CIRCUIT, ELECTRONIC DEVICE, AND STORAGE MEDIUM" and filed with the National Intellectual Property Administration on June 21, 2022.

### TECHNICAL FIELD

This application relates to the field of battery control technologies, and in particular, to an SOC calculation method, a control circuit, an electronic device, and a storage medium.

### BACKGROUND

The description herein provides only background information related to this application, but does not necessarily constitute the exemplary technology.

A state of charge (SOC) of a battery is an important parameter for describing an operating state of the battery, and is usually indicated by using a ratio of a battery level of the battery to an actual capacity of the battery. The SOC of the battery usually needs to be estimated according to parameters such as a voltage, charge and discharge currents, and internal resistance on the battery side. A user can determine the battery level according to the SOC of the battery, thereby facilitating control and management of the battery level.

During discharging of the battery, the voltage of the battery decreases as the battery level decreases. Correspondingly, the SOC also continuously decreases as the battery level decreases. However, during decreasing of the SOC, the SOC sharply decreases, for example, the SOC sharply decreases from a specific value to zero, resulting in an electricity consumption abnormality, and affecting electricity consumption planning of the user.

Document CN 111 289 902 A discloses an estimation method performing a process for adjusting a remaining capacity of a battery during a discharge when a current of the battery is less than zero, and performing the process for adjusting the remaining capacity of the battery during the discharge. A voltage of the battery is detected. A reference state of charge is inquired from a lookup table based on the detected voltage of the battery. A voltage threshold is subtracted from the detected voltage of the battery to obtain a voltage difference.

### SUMMARY

The invention is a method as defined by claim 1, a control circuit as defined in claim 9 and electronic device as defined in claim 10.

Various embodiments of this application provide an SOC calculation method, a control circuit, an electronic device, and a storage medium.

According to a first aspect, this application provides an SOC calculation method for a battery module, including:
obtaining a battery core voltage of a battery module in a discharging state;
obtaining a discharge parameter of the battery module when the battery core voltage is less than or equal to a preset voltage, where the preset voltage is greater than an under-voltage protection voltage of a battery module;
obtaining a first voltage difference between the preset voltage and the battery core voltage;
calculating a correction coefficient of an SOC according to the first voltage difference and the discharge parameter, where the correction coefficient is positively correlated with the discharge parameter and inversely correlated with the battery core voltage; and
calculating a value of the SOC according to a rated full-load capacity of the battery module, the discharge parameter, and the correction coefficient.

According to a second aspect, this application further provides a control circuit, including a processor, a memory, and a data bus configured to implement connection and communication between the processor and the memory, where the memory stores a computer program executable by the processor, and the computer program, when executed by the processor, implements the steps of the foregoing SOC calculation method.

According to a third aspect, this application further provides an electronic device, including:
a battery module;
one or more processors; and
a storage apparatus, configured to store one or more programs, where the one or more programs, when executed by the one or more processors, cause the electronic device to implement the foregoing SOC calculation method.

According to a fourth aspect, this application further provides a storage medium, storing one or more computer programs, where the one or more computer programs, when executed by the one or more processors, implement the steps of the foregoing SOC calculation method.

Details of one or more embodiments of this application are provided in the accompanying drawings and descriptions below. Other features, objectives, and advantages of this application become apparent from the specification, the accompanying drawings, and the claims.

### BRIEF DESCRIPTION OF THE DRAWINGS

To describe the technical solutions in the embodiments of this application more clearly, the following briefly describes the accompanying drawings required for describing the embodiments. Apparently, the accompanying drawings in the following descriptions show some embodiments of this application, and a person of ordinary skill in the art may derive other drawings from these accompanying drawings without creative efforts.
FIG. 1 is a schematic flowchart of steps of an SOC calculation method for a battery module according to an embodiment of this application;
FIG. 2 is a schematic flowchart of steps of another SOC calculation method for a battery module according to an embodiment of this application;
FIG. 3 is a schematic flowchart of steps of another SOC calculation method for a battery module according to an embodiment of this application;
FIG. 4 is a schematic block diagram of a structure of a control circuit according to an embodiment of this application; and
FIG. 5 is a schematic block diagram of a structure of an electronic device according to an embodiment of this application.

The objective implementation, functional features, and advantages of this application are further illustrated with reference to the embodiments and the accompanying drawings.

### DETAILED DESCRIPTION

The following clearly and completely describes technical solutions in the embodiments of this application with reference to the accompanying drawings in the embodiments of this application. Apparently, the described embodiments are some but not all of the embodiments of this application. All other embodiments obtained by a person skilled in the art based on the embodiments of this application without creative efforts fall within the protection scope of this application.

The embodiments of this application provide an SOC calculation method for a battery module, a control circuit, an electronic device, and a storage medium. The SOC calculation method is applicable to an electronic device. The electronic device is provided with a control circuit and a battery module. The control circuit may be a battery management system corresponding to the battery module.

For example, the electronic device may be an energy storage device. The energy storage device includes, for example, the battery module. The battery module includes one or more electric energy storage units. The electric energy storage unit is, for example, one or more batteries. The battery includes a battery core.

The following describes some implementations of this application with reference to the drawings. The following embodiments and features in the embodiments may be mutually combined in a case that no conflict occurs.

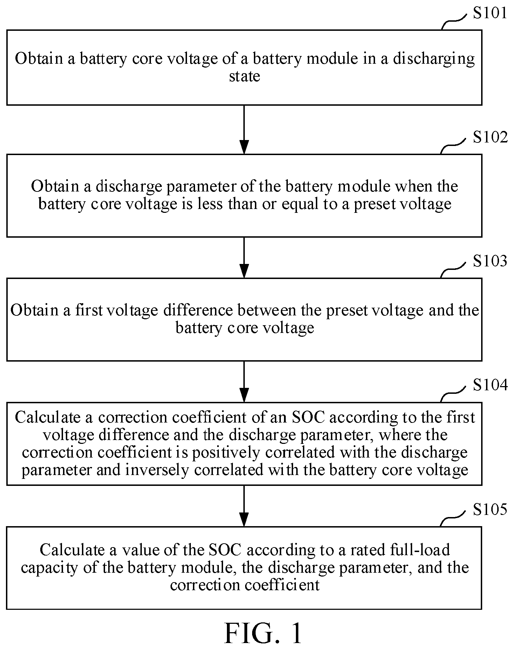

FIG. 1 is a schematic flowchart of steps of an SOC calculation method for a battery module according to an embodiment of this application. The SOC calculation method is applicable to a control circuit of an electronic device. The SOC calculation method includes the following steps:
S101: Obtain a battery core voltage of a battery module in a discharging state.

In the step, when the battery module is in the discharging state, the battery core voltage of the battery module decreases as the battery module discharges. In the step, battery parameters such as a battery level and an SOC of the battery module also decrease as the battery module discharges.

In the step, the battery module may include battery cores of a plurality of batteries, and battery core voltages of different batteries may be the same or may deviate within a specific range. In the step, the battery core voltage of the battery module may be a lowest battery core voltage among all battery core voltages. In the discharging state, the lowest battery core voltage among all the battery core voltages is used as the battery core voltage of the battery module, which can ensure that an under-voltage caused by over-discharging of a battery core does not occur during the discharging.

In the step, the battery core voltage may be acquired by a voltage sampling circuit and transmitted to the control circuit. In an embodiment, the control circuit may be a battery management system, and the BMS performs subsequent operation determining according to the battery core voltage.

For example, whether the battery module is currently in the discharging state may be determined by obtaining an on or off state of a discharge switch tube in the battery management system, or whether the battery module is in the discharging state may be obtained by using a value of a customized identifier field in the control circuit, so that the SOC of the battery module can be calculated by using the SOC calculation method in this embodiment when it is obtained that the battery module is in the discharging state.

S102: Obtain a discharge parameter of the battery module when the battery core voltage is less than or equal to a preset voltage.

In the step, the preset voltage is greater than an under-voltage protection voltage of a battery module. When the battery core voltage of the battery module is less than or equal to the under-voltage protection voltage, the control circuit enables under-voltage protection, so that output of the battery module is disabled. In other words, the discharge switch tube located on a discharge loop of the battery module may be turned off through the battery management system.

In the step, the preset voltage is greater than the under-voltage protection voltage of the battery module. The preset voltage may be set according to an actual requirement. For example, the preset voltage is set to be greater than the under-voltage protection voltage by a preset value. The preset value may be 0.5 V, 1 V, or even greater.

For example, the under-voltage protection voltage of the battery module is 3 V, and the preset voltage is 3.5 V. If the control circuit detects that the battery core voltage of the battery module is 3.3 V, and determines that the battery core voltage 3.3 V is less than or equal to the preset voltage 3.5 V, the discharge parameter of the battery module is obtained, and subsequent steps are performed.

In the step, the discharge parameter may include at least one of a discharge current and a resistance value of a discharge load. It should be noted that, the discharge current may be a current value currently output by the battery module, and the resistance value of the load may be a resistance value of a load currently connected to the battery module.

S103: Obtain a first voltage difference between the preset voltage and the battery core voltage.

In the step, when the battery core voltage is less than or equal to the preset voltage, the first voltage difference between the preset voltage and the battery core voltage is obtained. In the step, the first voltage difference is a voltage difference between a preset voltage v_{ref} and a battery core voltage v.

In the step, the operation of obtaining a first voltage difference between the preset voltage and the battery core voltage and the operation of obtaining a discharge parameter of the battery module may be simultaneously performed. In the step, the operation of obtaining a first voltage difference between the preset voltage and the battery core voltage may alternatively be performed before or after the operation of obtaining a discharge parameter of the battery module. This is not specifically limited in this embodiment.

S104: Calculate a correction coefficient of the SOC according to the first voltage difference and the discharge parameter, where the correction coefficient is positively correlated with the discharge parameter and inversely correlated with the battery core voltage.

In the step, the correction coefficient is used for representing a rate at which the SOC changes as the battery module discharges. In the battery discharging state, a larger correction coefficient indicates that a value of the SOC decreases faster as the battery module discharges, and a smaller correction coefficient indicates that the value of the SOC decreases slower as the battery module discharges.

In the step, the correction coefficient of the SOC is calculated according to the first voltage difference and the discharge parameter, where the correction coefficient is positively correlated with the discharge parameter and inversely correlated with the battery core voltage, so that the value of the SOC can be updated in time according to the calculated correction coefficient. For example, when the battery core voltage of the battery module decreases, the correction coefficient of the SOC is controlled to increase, to improve the rate at which the value of the SOC decreases as the battery module discharges, so that a decrease speed of the SOC of the battery module from the preset voltage to the under-voltage protection voltage becomes faster. In this way, when the battery core voltage of the battery module reaches the under-voltage protection voltage, the value of the SOC of the battery module is a minimum SOC value customized by a user or a default value. The minimum SOC value is, for example, 5%, and discharging is stopped when the SOC of the battery module decreases to 5%. The default value may be 0. In this way, when the battery core voltage of the battery module reaches the under-voltage protection voltage, it is ensured that the SOC is also updated to a non-dischargeable SOC value set by a system, thereby avoiding a sharp decrease in the SOC, for example, avoiding a case in which the SOC sharply decreases to zero.

In addition, when the battery core voltage of the battery module ranges from the preset voltage to the under-voltage protection voltage, a decrease rate of the SOC becomes faster, which may also play a role of a prompt warning, for the user to predict an actual situation according to the value of the SOC and the change of the value of the SOC, to perform electricity consumption planning in advance.

In this embodiment, a larger discharge current of the battery module indicates a larger correction coefficient of the SOC, and a larger resistance value of the discharge load connected to the battery module indicates a larger correction coefficient of the SOC. A smaller battery core voltage of the battery module indicates a larger correction coefficient of the SOC. When the battery core voltage is smaller, the first voltage difference between the preset voltage and the battery core voltage is larger, and the corresponding correction coefficient of the SOC is larger.

S105: Calculate the value of the SOC according to a rated full-load capacity of the battery module, the discharge parameter, and the correction coefficient.

In the step, the rated full-load capacity may be a rated capacity when the battery module is fully charged, the discharge parameter may include parameters such as the discharge current and a discharge capacity of the battery module, and the correction coefficient is calculated according to the first voltage difference and the discharge parameter. The SOC calculation method may use a conventional ampere-hour integral method.

In the step, the rated full-load capacity of the battery module remains unchanged, and the discharge parameter and the correction coefficient change as the battery module discharges. In the step, the value of the SOC can be accurately calculated according to the rated full-load capacity of the battery module, the discharge parameter, and the correction coefficient, so that the value of the SOC can be adjusted in real time, and the decrease speed of the SOC of the battery module from the preset voltage to the under-voltage protection voltage becomes faster. In this way, when the battery core voltage of the battery module reaches the under-voltage protection voltage, the SOC can decrease to the preset value, to avoid a sharp decrease in the SOC, thereby avoiding an electricity consumption abnormality caused by the sharp decrease in the SOC, and avoiding affecting electricity consumption planning of the user.

In the step, when the battery core voltage of the battery module in the discharging state is less than or equal to the preset voltage, the correction coefficient of the SOC may be adjusted according to the first voltage difference between the preset voltage and the battery core voltage and the discharge parameter. Because the correction coefficient is positively correlated with the discharge parameter and inversely correlated with the battery core voltage, during the discharging of the battery module, the correction coefficient increases in a period of time that the battery core voltage decreases from the preset voltage to the under-voltage protection voltage. In this way, the decrease rate of the SOC is improved, so that when the battery core voltage of the battery module reaches the under-voltage protection voltage, the value of the SOC of the battery module is the minimum SOC value customized by the user or the default value. The minimum SOC value is, for example, 5%, and the default value is, for example, 0.

According to the SOC calculation method provided in the foregoing embodiment, a battery core voltage of a battery module in a discharging state is obtained; a discharge parameter of the battery module is obtained when the battery core voltage is less than or equal to a preset voltage, where the preset voltage is greater than an under-voltage protection voltage of a battery module; a correction coefficient of an SOC is calculated according to a first voltage difference between the preset voltage and the battery core voltage and the discharge parameter, where the correction coefficient is positively correlated with the discharge parameter and inversely correlated with the battery core voltage; and a value of the SOC is calculated according to a rated full-load capacity of the battery module, the discharge parameter, and the correction coefficient. In the manner, when it is determined that the battery core voltage of the battery module in the discharging state is less than the preset voltage, the correction coefficient of the SOC is calculated according to the first voltage difference and the discharge parameter, and a decrease rate of the SOC may be adjusted by using the correction coefficient. The SOC of the battery module changes at a faster decrease speed, to ensure that the SOC can decrease to a preset value when the battery core voltage decreases to the under-voltage protection voltage. The preset value may be a minimum SOC value set by a user for allowing discharging or may be a default value, to avoid a sharp decrease in the SOC during discharging, thereby avoiding an electricity consumption abnormality caused by the sharp decrease in the SOC, and avoiding affecting electricity consumption planning of the user.

For example, the under-voltage protection voltage of the battery module is 3 V, the preset voltage is 3.5 V, and the current battery core voltage of the battery module is 3.3 V. When a control circuit in this application detects that the battery core voltage 3.3 V is less than or equal to the preset voltage 3.5 V, the discharge parameter of the battery module and the first voltage difference between the preset voltage and the battery core voltage are obtained, and the correction coefficient of the SOC is adjusted by using the discharge parameter and the first voltage difference, to adjust the decrease rate of the SOC, so that the SOC can change at the faster decrease speed, thereby avoiding the sharp decrease in the SOC. In addition, by using the solution of this application, the user can be provided with a warning, to prompt the user of a discharge status of the battery module, so that the user can properly arrange electricity consumption planning according to the SOC, thereby improving user experience.

For example, when the battery core voltage of the battery module is 3.5 V, the corresponding SOC is 20%, and in this case, the correction coefficient of the SOC is 1. When the battery core voltage of the battery module is 3.3 V, the corresponding SOC is 15%, and in this case, the correction coefficient of the SOC is 1.1. When the battery core voltage of the battery module is 3.1 V, the corresponding SOC is 8%, and in this case, the correction coefficient of the SOC is 1.2. When the battery core voltage of the battery module is equal to the under-voltage protection voltage 3 V, the correction coefficient of the SOC is 1.3, and in this case, the SOC decreases to a preset value 0.

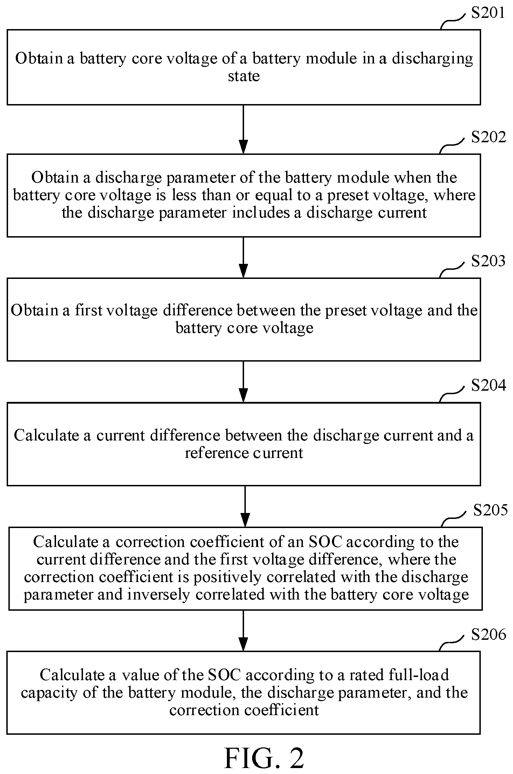

FIG. 2 is a schematic flowchart of steps of another SOC calculation method for a battery module according to an embodiment of this application.

As shown in FIG. 2, the SOC calculation method for a battery module includes step S201 to step S206.

Step S201: Obtain a battery core voltage of a battery module in a discharging state.

The battery module may include one or more battery cores. When the battery module includes a plurality of battery cores, the battery core voltage may be a lowest voltage among voltages of the plurality of battery cores.

It should be noted that, when the battery module is in the discharging state, under-voltage protection is enabled when the battery core voltage is less than or equal to an under-voltage protection voltage. Therefore, the lowest voltage among the voltages of the plurality of battery cores is used as the battery core voltage of the battery module, to ensure that the under-voltage protection for the battery module can be enabled in time and effectively.

In an embodiment, the battery core voltage of the battery module is acquired at a first sampling frequency when the battery core voltage is greater than a preset voltage; and the battery core voltage of the battery module is acquired at a second sampling frequency when the battery core voltage is less than or equal to the preset voltage, where the second sampling frequency is higher than the first sampling frequency, and the first sampling frequency and the second sampling frequency may be set according to an actual situation.

It should be noted that, when the battery core voltage is greater than the preset voltage, there is no need to adjust a correction coefficient of an SOC. Therefore, the battery core voltage of the battery module is acquired at the first sampling frequency with a lower sampling frequency. The first sampling frequency is, for example, once every 10 minutes, so that a value of the SOC does not sharply decrease. When the battery core voltage is less than or equal to the preset voltage, it is necessary to avoid a sharp decrease in the value of the SOC. Therefore, the battery core voltage of the battery module is acquired at the second sampling frequency with a higher sampling frequency. The second sampling frequency is, for example, once every 2 minutes, so that adjustment precision of the value of the SOC can be improved.

In an embodiment, the SOC calculation method provided in this embodiment of this application may be performed according to the first sampling frequency or the second sampling frequency. To be specific, after a control circuit obtains the battery core voltage of the battery module in the discharging state, according to a comparison relationship between the preset voltage and the battery core voltage, it may be determined whether to acquire the battery core voltage of the battery module at the first sampling frequency or the second sampling frequency, and subsequent steps of the SOC calculation method are performed. When the battery core voltage is less than or equal to the preset voltage, the battery core voltage of the battery module is acquired at the second sampling frequency with a higher sampling frequency, so that adjustment precision of the value of the SOC can be improved.

For example, the battery core voltage of the battery module in the discharging state is obtained, and it is determined whether the battery core voltage is less than or equal to the preset voltage. If the battery core voltage is greater than the preset voltage, the battery core voltage of the battery module is acquired at the first sampling frequency, the correction coefficient of the SOC is determined as 1, and the value of the SOC is calculated by using the correction coefficient 1. If the battery core voltage is less than or equal to the preset voltage, the battery core voltage of the battery module is acquired at the second sampling frequency, the correction coefficient of the SOC is calculated according to a first voltage difference between the preset voltage and the battery core voltage and a discharge parameter of the battery module, and the value of the SOC is calculated according to a rated full-load capacity of the battery module, the discharge parameter, and the correction coefficient.

Step S202: Obtain the discharge parameter of the battery module when the battery core voltage is less than or equal to the preset voltage, where the discharge parameter includes a discharge current.

The preset voltage is greater than the under-voltage protection voltage of a battery module. When the battery core voltage is less than or equal to the under-voltage protection voltage, the SOC of the battery module may sharply decrease to zero. Therefore, when the battery core voltage is greater than the under-voltage protection voltage and less than or equal to the preset voltage, the discharge parameter of the battery module such as the discharge current is obtained to perform subsequent related steps of the SOC calculation method. In this way, a decrease rate of the SOC can be properly adjusted through calculation of the correction coefficient of the SOC, thereby avoiding a case in which the value of the SOC sharply decreases to zero.

In an embodiment, if the battery core voltage is greater than the preset voltage, there is no need to perform the subsequent steps. For example, when the battery core voltage is greater than the preset voltage, a battery level of the battery module is large, and the value of the SOC does not sharply decrease. Therefore, the correction coefficient of the SOC may be determined as 1, and the value of the SOC is calculated by using the correction coefficient 1 of the SOC, and there is no need to adjust the decrease rate of the SOC.

Step S203: Obtain the first voltage difference between the preset voltage and the battery core voltage.

The first voltage difference is a voltage difference between the preset voltage and the battery core voltage. The first voltage difference is obtained by calculating the difference between the preset voltage and the battery core voltage.

In an embodiment, the step of obtaining the first voltage difference may be performed simultaneously with the step of obtaining the discharge current of the battery module, or may be performed before or after the step of obtaining the discharge current.

Step S204: Calculate a current difference between the discharge current and a reference current.

The discharge current may be a current value output by the battery module, and the reference current may be a reference value of an output current of the battery module. The reference current may be set according to an actual situation of the battery module. The reference current is, for example, 5 A.

In an embodiment, it is determined whether the discharge current is greater than the reference current. The current difference between the discharge current and the reference current is calculated when the discharge current is greater than the reference current. It should be noted that, the current difference between the discharge current and the reference current needs to be a positive value. Therefore, when the discharge current is greater than the reference current, the current difference between the discharge current and the reference current is calculated, which can ensure that no error occurs in a calculation result of the correction coefficient of the SOC.

Step S205: Calculate the correction coefficient of the SOC according to the current difference and the first voltage difference, where the correction coefficient is positively correlated with the discharge parameter and inversely correlated with the battery core voltage.

It should be noted that, the correction coefficient of the SOC is calculated according to the first voltage difference and the discharge parameter, so that the value of the SOC can be updated in time according to the calculated correction coefficient. A larger current difference and a larger first voltage difference indicate a larger calculated correction coefficient. A larger calculated correction coefficient indicates that the value of the SOC decreases faster as the battery module discharges.

In an embodiment, the correction coefficient of the SOC is calculated by using the following formula: $K = 1 + a \times \left(i-{i}_{ref}\right) \times \left({v}_{ref}-v\right)$

K indicates the correction coefficient of the SOC, a indicates a preset constant greater than zero and less than 1, i indicates the discharge current, i_{ref} indicates the reference current, v_{ref} indicates the preset voltage, and v indicates the battery core voltage. It should be noted that, i-i_{ref} indicates the current difference, v_{ref}-v indicates the first voltage difference, and the preset constant a may be set according to an actual situation, for example, a may be 0.5. The current difference i-i_{ref} and the first voltage difference v_{ref}-v are substituted into the foregoing formula for calculation, so that the correction coefficient K of the SOC can be quickly obtained.

It should be noted that, the K correction coefficient of the SOC may be obtained by adding a product of the preset constant, the current difference, and the first voltage difference to the constant 1. When the battery core voltage is less than or equal to the preset voltage, the correction coefficient K of the SOC can increase, to improve the decrease rate of the SOC. For example, when the battery core voltage of the battery module decreases, the correction coefficient of the SOC is controlled to increase, to improve the rate at which the value of the SOC decreases as the battery module discharges. In this way, a decrease speed of the SOC of the battery module from the preset voltage to the under-voltage protection voltage becomes faster, so that the value of the SOC does not sharply decrease during the discharging of the battery module.

In an embodiment, before the correction coefficient of the SOC is calculated according to the current difference and the first voltage difference, it is determined whether a battery level of the battery module is less than or equal to a preset battery level; and the step of calculating the correction coefficient of the SOC according to the first voltage difference and the current difference if the battery level of the battery module is less than or equal to the preset battery level.

The preset battery level may be set according to an actual situation of the battery module, and the preset battery level is less than the rated full-load capacity of the battery module. It should be noted that, after the battery level of the battery module is less than or equal to the preset battery level, the value of the SOC may sharply decrease. Therefore, the step of calculating the correction coefficient of the SOC according to the first voltage difference and the current difference needs to be performed, to ensure necessity of performing adjustment calculation on the correction coefficient of the SOC, thereby avoiding a sharp decrease in the value of the SOC.

For example, if the rated full-load capacity is 10000 mA and the preset battery level is 2000 mA, when the battery level of the battery module is less than or equal to 2000 mA, the SOC may sharply decrease to a preset value due to an under-voltage. Therefore, when it is detected that the battery level of the battery module is less than or equal to the preset battery level 2000 mA, the decrease rate of the SOC may be controlled to increase by using an increase in the correction coefficient of the SOC, for example, the correction coefficient of the SOC is greater than 1, so that the decrease rate of the SOC increases, and a sharp decrease in the value of the SOC can be avoided.

In an embodiment, the correction coefficient is updated to 1 when the battery core voltage is greater than the preset voltage or when the battery module is not in the discharging state. It should be noted that, during operating of the battery module, an operating state of the battery module changes. A factor such as the battery module being in a charging state or the battery module stopping discharging may cause the battery core voltage of the battery module to increase, so that the battery core voltage is greater than the preset voltage. In this case, the value of the SOC does not sharply decrease to zero. In an initial discharging stage of the battery module, the battery core voltage is also greater than the preset voltage. Therefore, when the battery core voltage is greater than the preset voltage or when the battery module is not in the discharging state, the correction coefficient is updated to 1, so that there is no need to calculate the correction coefficient of the SOC according to the current difference and the first voltage difference, and the correction coefficient of the SOC can be quickly obtained.

Step S206: Calculate the value of the SOC according to the rated full-load capacity of the battery module, the discharge parameter, and the correction coefficient.

The value of the SOC may be accurately calculated according to the rated full-load capacity of the battery module, the discharge parameter, and the correction coefficient. The discharge parameter includes a discharge capacity or the discharge current of the battery module. It should be noted that, the value of the SOC is accurately calculated according to the rated full-load capacity of the battery module, the discharge parameter, and the correction coefficient, so that the value of the SOC can be adjusted in real time, and it can be ensured that a sharp decrease in the value of the SOC can be avoided during the discharging of the battery module, thereby avoiding affecting electricity consumption planning of a user due to an inaccurate value of the SOC.

For example, the value of the SOC is calculated by using the following formula: $SOC = \left(fullcap-K*\int Idt\right) / fullcap$ *fullcap* indicates the rated full-load capacity of the battery module, ∫*Idt* indicates the discharge capacity of the battery module, and *K* indicates the correction coefficient of the SOC. It should be noted that, the discharge capacity of the battery module may be obtained by obtaining an integral value of the discharge current of the battery module, and the rated full-load capacity of the battery module, the discharge parameter, and the correction coefficient are substituted into the foregoing formula for calculation, so that the value of the SOC can be quickly and accurately obtained.

For example, the under-voltage protection voltage of the battery module is 3.0 V, and the preset voltage is 3.5 V. When the battery core voltage of the battery module reaches 3.3 V, as the battery core voltage continues to decrease, there is a high probability that the SOC sharply decreases to the preset value, for example, zero, due to an under-voltage. Therefore, when it is detected that the battery core voltage is less than or equal to the preset voltage 3.5 V, the decrease rate of the SOC may be controlled to increase by using an increase in the correction coefficient of the SOC. For example, the correction coefficient is 1, and the calculated correction coefficient is 1.05. The value of the SOC can change at a faster decrease speed as the correction coefficient increases, so that when the battery core voltage of the battery module reaches the under-voltage protection voltage 3.0 V, the SOC can decrease to the preset value. The preset value may be 0 or may be a minimum SOC value set by a user for allowing discharging, thereby avoiding a case in which the value of the SOC sharply decreases to zero, and avoiding an electricity consumption abnormality caused by the SOC sharply decreasing to zero.

According to the SOC calculation method for a battery module provided in the foregoing embodiment, when it is determined that a battery core voltage of a battery module in a discharging state is near an under-voltage protection voltage, a correction coefficient of an SOC is calculated according to a first voltage difference and a current difference, to adjust the correction coefficient of the SOC, so that a decrease speed of the SOC of the battery module from a preset voltage to the under-voltage protection voltage becomes faster. In this way, when the battery core voltage of the battery module reaches the under-voltage protection voltage, a value of the SOC is calculated as a preset value. The preset value may be a minimum SOC value set by a user for allowing discharging or may be a default value, thereby avoiding a sharp decrease in the SOC during discharging of the battery module, and avoiding an electricity consumption abnormality caused by the sharp decrease in the SOC.

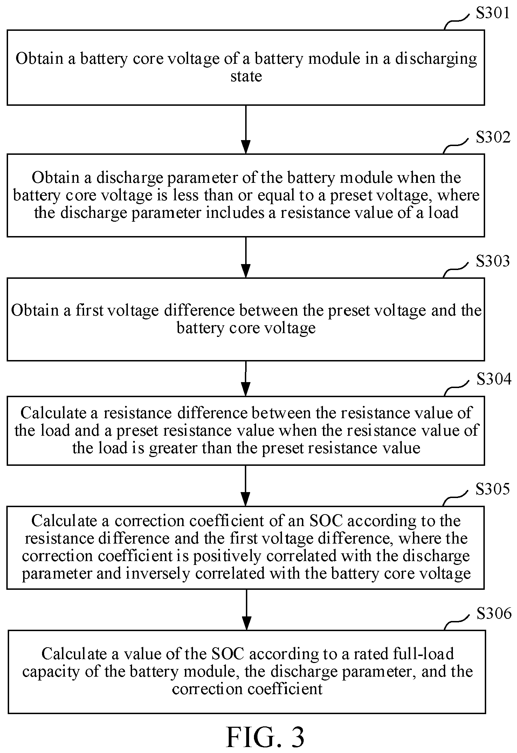

FIG. 3 is a schematic flowchart of steps of another SOC calculation method for a battery module according to an embodiment of this application.

As shown in FIG. 3, the SOC calculation method includes step S301 to step S306.

Step S301: Obtain a battery core voltage of a battery module in a discharging state.

Step S302: Obtain a discharge parameter of the battery module when the battery core voltage is less than or equal to a preset voltage, where the discharge parameter includes a resistance value of a load.

The preset voltage is greater than an under-voltage protection voltage of a battery module. When the battery core voltage is less than or equal to the under-voltage protection voltage, an SOC of the battery module may sharply decrease to zero. Therefore, when the battery core voltage is greater than the under-voltage protection voltage and less than or equal to the preset voltage, the discharge parameter of the battery module such as the resistance value of the load is obtained to perform subsequent related steps of the SOC calculation method. In this way, a decrease rate of the SOC can be properly adjusted through calculation of a correction coefficient of the SOC, thereby ensuring stability of decreasing of the SOC, and avoiding a case in which a value of the SOC sharply decreases to zero.

In an embodiment, if the battery core voltage is greater than the preset voltage, it is determined that a correction coefficient K of the SOC is equal to 1, and there is no need to obtain the discharge parameter of the battery module such as the resistance value of the load. In another embodiment, if the battery core voltage is less than or equal to the preset voltage and the battery module is not in the discharging state, it is determined that the correction coefficient K of the SOC is equal to 1, and in this case, the value of the SOC does not sharply decrease to zero. Therefore, there is also no need to obtain the discharge parameter of the battery module such as the resistance value of the load.

Step S303: Obtain a first voltage difference between the preset voltage and the battery core voltage.

The first voltage difference is a voltage difference between the preset voltage and the battery core voltage. The first voltage difference is obtained by calculating the difference between the preset voltage and the battery core voltage.

In an embodiment, the step of obtaining a first voltage difference may be performed simultaneously with the step of obtaining a resistance value of a load, or may be performed before or after the step of obtaining a resistance value of a load.

Step S304: Calculate a resistance difference between the resistance value of the load and a preset resistance value when the resistance value of the load is greater than the preset resistance value.

It is determined whether the resistance value of the load is greater than the preset resistance value. When the resistance value of the load is greater than the preset resistance value, the resistance difference between the resistance value of the load and the preset resistance value is calculated. The preset resistance value may be set according to an actual situation.

It should be noted that, when the resistance value of the load is less than or equal to the preset resistance value, the value of the SOC is not likely to sharply decrease to zero. Therefore, the resistance difference is calculated only when the resistance value of the load is greater than the preset resistance value, to calculate the correction coefficient of the SOC according to the resistance difference and the first voltage difference, thereby adjusting the decrease rate of the SOC during discharging of a battery module.

Step S305: Calculate the correction coefficient of the SOC according to the resistance difference and the first voltage difference, where the correction coefficient is positively correlated with the discharge parameter and inversely correlated with the battery core voltage.

It should be noted that, the correction coefficient of the SOC is calculated according to the resistance difference and the first voltage difference, so that the value of the SOC can be updated in time according to the calculated correction coefficient. A larger resistance difference and a larger first voltage difference indicate a larger calculated correction coefficient. A larger calculated correction coefficient indicates that the value of the SOC decreases faster as the battery module discharges, thereby ensuring that the value of the SOC does not sharply decrease during the discharging of the battery module.

In an embodiment, the resistance difference and the first voltage difference are substituted into a preset formula for calculation, so that the correction coefficient of the SOC can be obtained. The preset formula may be set according to a specific situation. For example, reference may be made to the foregoing embodiment of calculating the correction coefficient of the SOC according to the current difference and the first voltage difference. Details are not described again in this embodiment.

In an embodiment, before the step of calculating the correction coefficient of the SOC according to the resistance difference and the first voltage difference, it is determined whether a battery level of the battery module is less than or equal to a preset battery level; and the step of calculating the correction coefficient of the SOC according to the resistance difference and the first voltage difference if the battery level of the battery module is less than or equal to the preset battery level. The preset battery level is less than a rated full-load capacity of the battery module. It should be noted that, after the battery level of the battery module is greater than the preset battery level, the value of the SOC may sharply decrease to zero. Therefore, the step of calculating the correction coefficient of the SOC according to the first voltage difference and the resistance difference needs to be performed, thereby avoiding a sharp decrease in the value of the SOC.

Step S306: Calculate the value of the SOC according to the rated full-load capacity of the battery module, the discharge parameter, and the correction coefficient.

The value of the SOC may be accurately calculated according to the rated full-load capacity of the battery module, the discharge parameter, and the correction coefficient. The discharge parameter includes a discharge capacity of the battery module. It should be noted that, the value of the SOC is accurately calculated according to the rated full-load capacity of the battery module, the discharge parameter, and the correction coefficient, so that the value of the SOC can be adjusted in real time, and a sharp decrease in the value of the SOC can be avoided.

In an embodiment, after the value of the SOC is calculated, the value of the SOC is displayed by a display apparatus. The display apparatus is, for example, a display screen, which is convenient for a user to properly control and manage the battery level according to the value of the SOC displayed on the display apparatus. The value of the SOC displayed on the display apparatus is not likely to sharply decrease to zero, thereby greatly improving user experience.

In an embodiment, after the value of the SOC is displayed by the display apparatus, if it is determined that the battery core voltage of the battery module is greater than the preset voltage or when the battery module is not in the discharging state, the correction coefficient is updated to 1, the value of the SOC is calculated according to the rated full-load capacity of the battery module, the discharge parameter, and the correction coefficient, and then the value of the SOC is displayed by the display apparatus, so that the user can properly perform electricity consumption planning.

According to the SOC calculation method for a battery module provided in the foregoing embodiment, when it is determined that a battery core voltage of a battery module in a discharging state is small, a correction coefficient of an SOC is adjusted according to a resistance difference between a resistance value of a load and a preset resistance value and a first voltage difference, so that a decrease speed of the SOC of the battery module from a preset voltage to an under-voltage protection voltage becomes faster. In this way, when the battery core voltage decreases to the under-voltage protection voltage, it is ensured that the SOC can decrease to a preset value. The preset value may be a minimum SOC value set by a user for allowing discharging or may be a default value, thereby avoiding a sharp decrease in a value of the SOC, and avoiding an electricity consumption abnormality caused by the sharp decrease in the SOC.

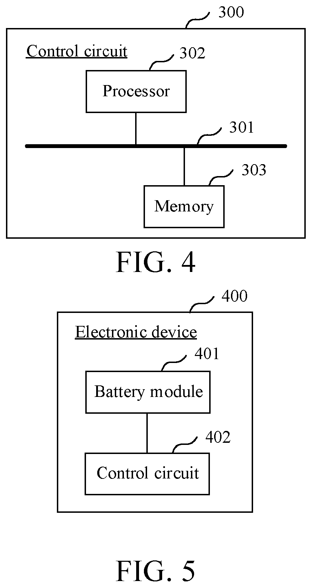

FIG. 4 is a schematic block diagram of a structure of a control circuit according to an embodiment of this application.

As shown in FIG. 4, a control circuit 300 includes a processor 302 and a memory 303 connected through a system bus 301. The memory 303 may include a non-volatile storage medium and an internal memory.

The non-volatile storage medium may store an operating system and a computer program. The computer program includes program instructions, and when the program instructions are executed, the processor 302 is caused to perform any one of the SOC calculation methods.

The processor 302 is configured to provide computing and control capabilities to support operation of the entire control circuit 300.

The internal memory provides running of the computer program stored in the non-volatile storage medium with an environment, and when the computer program is executed by the processor 302, the processor 302 is caused to perform any one of the SOC calculation methods.

The control circuit 300 may further include a network interface. The network interface is configured to perform network communication, such as sending an assigned task. A person skilled in the art may understand that, the structure shown in FIG. 4 is only a block diagram of a part of a structure related to a solution of this application and does not limit the control circuit 300 to which the solution of this application is applied. Specifically, the control circuit 300 may include more or fewer components than those in the drawings, or some components are combined, or a different component deployment is used.

It should be understood that, the processor 302 may be a central processing unit (CPU). The processor 302 may also be another general-purpose processor, a digital signal processor (DSP), an application specific integrated circuit (ASIC), a field-programmable gate array (FPGA), another programmable logic device, a discrete gate or a transistor logic device, a discrete hardware component, or the like. The general-purpose processor may be a microprocessor, or the processor may be any conventional processor or the like.

In an embodiment, the processor 302 is configured to execute the computer program stored in the memory, to implement the following steps:
obtaining a battery core voltage of a battery module in a discharging state;
obtaining a discharge parameter of the battery module when the battery core voltage is less than or equal to a preset voltage, where the preset voltage is greater than an under-voltage protection voltage of a battery module;
obtaining a first voltage difference between the preset voltage and the battery core voltage;
calculating a correction coefficient of an SOC according to the first voltage difference and the discharge parameter, where the correction coefficient is positively correlated with the discharge parameter and inversely correlated with the battery core voltage; and
calculating a value of the SOC according to a rated full-load capacity of the battery module, the discharge parameter, and the correction coefficient.

In an embodiment, when implementing the step of obtaining a battery core voltage of a battery module in a discharging state, the processor 302 is configured to:
acquire the battery core voltage of the battery module at a first sampling frequency when the battery core voltage is greater than the preset voltage; and
acquire the battery core voltage of the battery module at a second sampling frequency when the battery core voltage is less than or equal to the preset voltage, where the second sampling frequency is higher than the first sampling frequency.

In an embodiment, the discharge parameter includes a discharge current; and when calculating the correction coefficient of the SOC according to the first voltage difference and the discharge parameter, the processor 302 is configured to:
calculate a current difference between the discharge current and a reference current; and
calculate the correction coefficient of the SOC according to the current difference and the first voltage difference.

In an embodiment, when calculating the correction coefficient of the SOC according to the current difference and the first voltage difference, the processor 302 is configured to:
calculate the correction coefficient of the SOC by using the following formula: $K = 1 + a \times \left(i-{i}_{ref}\right) \times \left({v}_{ref}-v\right)$
where K indicates the correction coefficient of the SOC, a indicates a preset constant greater than zero and less than 1, i indicates the discharge current, i_{ref} indicates the reference current, v_{ref} indicates the preset voltage, and v indicates the battery core voltage.

In an embodiment, the processor 302 is further configured to:
update the correction coefficient to 1 when the battery core voltage is greater than the preset voltage or when the battery module is not in the discharging state.

In an embodiment, the discharge parameter includes a resistance value of a load; and after calculating the correction coefficient of the SOC according to the first voltage difference and the discharge parameter, the processor 302 is further configured to:
calculate a resistance difference between the resistance value of the load and a preset resistance value when the resistance value of the load is greater than the preset resistance value; and
calculate the correction coefficient of the SOC according to the resistance difference and the first voltage difference.

In an embodiment, the discharge parameter includes a discharge capacity; and before implementing the step of calculating a correction coefficient of an SOC according to the first voltage difference and the discharge parameter, the processor 302 is further configured to:
determine whether a battery level of the battery module is less than or equal to a preset battery level; and
perform the step of calculating a correction coefficient of an SOC according to the first voltage difference and the discharge parameter if the battery level of the battery module is less than or equal to the preset battery level.

It should be noted that, a person skilled in the art may clearly understand that, for simple and clear description, for specific work processes of the foregoing described control circuit 300, reference may be made to corresponding processes in embodiments of the foregoing SOC calculation method, and details are not described herein again.

FIG. 5 is a schematic block diagram of a structure of an electronic device according to an embodiment of this application.

As shown in FIG. 5, the electronic device 400 includes a battery module 401 and a control circuit 402. The control circuit 402 is connected to the battery module 401, and the control circuit 402 may be used as a battery management system (BMS) of the battery module 401. The control circuit 402 is configured to calculate an SOC of the battery module 401.

The battery module 401 includes one or more electric energy storage units. The electric energy storage unit is, for example, one or more batteries. The battery includes a battery core. The control circuit 402 may be the control circuit 300 in the foregoing embodiment. The electronic device 400 may be, for example, an energy storage device.

This application further provides an electronic device, including: a battery module; one or more processors; and a storage apparatus, configured to store one or more programs, where the one or more programs, when executed by the one or more processors, cause the electronic device to implement the foregoing SOC calculation method.

An embodiment of this application further provides a computer-readable storage medium, storing one or more computer programs, where the one or more computer programs include program instructions, and the program instructions may be executed by the one or more processors. For the method implemented when the program instructions are executed, reference may be made to various embodiments of the SOC calculation method in this application.

The computer-readable storage medium may be an internal storage unit of the control circuit or the electronic device described in the foregoing embodiments, for example, a hard disk or a memory of the control circuit or the electronic device. The computer-readable storage medium may alternatively be an external storage device of the control circuit or the computer device, for example, a removable hard disk, a smart media card (SMC), a secure digital (SD) card, or a flash card equipped on the control circuit or the electronic device.

The sequence numbers of the foregoing embodiments of this application are merely for description purpose, and are not intended to indicate priorities of the embodiments. The foregoing descriptions are merely specific implementations of this application, but are not intended to limit the protection scope of this application. Any equivalent modification or replacement readily figured out by a person skilled in the art within the technical scope as defined by the independent claims of this application shall fall within the protection scope of this application. Therefore, the protection scope of this application shall be subject to the protection scope of the claims.

## Claims

1. An SOC calculation method for a battery module, comprising:
obtaining (S101, S201) a battery core voltage of a battery module in a discharging state;
obtaining (S102, S202) a discharge parameter of the battery module when the battery core voltage is less than or equal to a preset voltage, wherein the preset voltage is greater than an under-voltage protection voltage of a battery module;
obtaining (S103, S203) a first voltage difference between the preset voltage and the battery core voltage;
**characterised by** calculating (S104, S205) a correction coefficient of an SOC according to the first voltage difference and the discharge parameter, wherein the correction coefficient is positively correlated with the discharge parameter and inversely correlated with the battery core voltage; and
calculating (S105, S206) a value of the SOC according to a rated full-load capacity of the battery module, the discharge parameter, and the correction coefficient.

2. The SOC calculation method according to claim 1, wherein the step of obtaining a battery core voltage of a battery module in a discharging state comprises:
acquiring the battery core voltage of the battery module at a first sampling frequency when the battery core voltage is greater than the preset voltage; and
acquiring the battery core voltage of the battery module at a second sampling frequency when the battery core voltage is less than or equal to the preset voltage, wherein the second sampling frequency is higher than the first sampling frequency.

3. The SOC calculation method according to claim 1, wherein the discharge parameter comprises a discharge current; and
the calculating a correction coefficient of an SOC according to the first voltage difference and the discharge parameter comprises:
calculating a current difference between the discharge current and a reference current; and
calculating the correction coefficient of the SOC according to the current difference and the first voltage difference.

4. The SOC calculation method according to claim 3, wherein the calculating the correction coefficient of the SOC according to the current difference and the first voltage difference comprises:
calculating the correction coefficient of the SOC by using the following formula: $K = 1 + a \times \left(i-{i}_{ref}\right) \times \left({v}_{ref}-v\right)$
wherein K indicates the correction coefficient of the SOC, a indicates a preset constant greater than zero and less than 1, i indicates the discharge current, i_{ref} indicates the reference current, v_{ref} indicates the preset voltage, and v indicates the battery core voltage.

5. The SOC calculation method according to claim 1, wherein the method further comprises: updating the correction coefficient to 1 when the battery core voltage is greater than the preset voltage or when the battery module is not in the discharging state.

6. The SOC calculation method according to claim 1, wherein the discharge parameter comprises a resistance value of a load; and
the calculating a correction coefficient of an SOC according to the first voltage difference and the discharge parameter comprises:
calculating a resistance difference between the resistance value of the load and a preset resistance value when the resistance value of the load is greater than the preset resistance value; and
calculating the correction coefficient of the SOC according to the resistance difference and the first voltage difference.

7. The SOC calculation method according to any one of claims 1 to 5, wherein before the step of calculating a correction coefficient of an SOC according to the first voltage difference and the discharge parameter, the method further comprises:
determining whether a battery level of the battery module is less than or equal to a preset battery level; and
performing the step of calculating a correction coefficient of an SOC according to the first voltage difference and the discharge parameter if the battery level of the battery module is less than or equal to the preset battery level.

8. The SOC calculation method according to any one of claims 1 to 6, wherein the step of calculating a value of the SOC according to a rated full-load capacity of the battery module, the discharge parameter, and the correction coefficient comprises:
calculating the value of the SOC by using the following formula: $SOC = \left(fullcap-K*\int Idt\right) / fullcap$
wherein *fullcap* indicates the rated full-load capacity of the battery module, ∫*Idt* indicates a discharge capacity of the battery module, and *K* indicates the correction coefficient.

9. A control circuit (300), comprising a processor (302), a memory (303), and a data bus (301) configured to implement connection and communication between the processor and the memory, wherein the memory stores a computer program executable by the processor, and the computer program, when executed by the processor, implements the steps of the SOC calculation method according to any one of claims 1 to 8.

10. An electronic device (400), comprising:
a battery module (401);
one or more processors (302, 402); and
a storage apparatus (303, 402), configured to store one or more programs, wherein the one or more programs, when executed by the one or more processors, cause the electronic device to implement the SOC calculation method according to any one of claims 1 to 8.

## Patentansprüche

1. SOC-Berechnungsverfahren für ein Batteriemodul, umfassend:
Ermitteln (S101, S201) einer Batteriekernspannung eines Batteriemoduls in einem Entladezustand;
Ermitteln (S102, S202) eines Entladungsparameters des Batteriemoduls, wenn die Batteriekernspannung kleiner oder gleich einer voreingestellten Spannung ist, wobei die voreingestellte Spannung größer als eine Unterspannungsschutzspannung eines Batteriemoduls ist;
Ermitteln (S103, S203) einer ersten Spannungsdifferenz zwischen der voreingestellten Spannung und der Batteriekernspannung;
**gekennzeichnet durch** das Berechnen (S104, S205) eines SOC-Korrekturkoeffizienten anhand der ersten Spannungsdifferenz und des Entladungsparameters, wobei der Korrekturkoeffizient positiv mit dem Entladungsparameter und umgekehrt mit der Batteriekernspannung korreliert; und
Berechnen (S105, S206) eines SOC-Werts anhand einer Nennvollastkapazität des Batteriemoduls, des Entladungsparameters und des Korrekturkoeffizienten.

2. SOC-Berechnungsverfahren nach Anspruch 1, wobei der Schritt zum Ermitteln einer Batteriekernspannung eines Batteriemoduls in einem Entladezustand Folgendes umfasst:
Erfassen der Batteriekernspannung des Batteriemoduls mit einer ersten Abtastfrequenz, wenn die Batteriekernspannung größer als die voreingestellte Spannung ist; und
Erfassen der Batteriekernspannung des Batteriemoduls mit einer zweiten Abtastfrequenz, wenn die Batteriekernspannung kleiner oder gleich der voreingestellten Spannung ist, wobei die zweite Abtastfrequenz höher als die erste Abtastfrequenz ist.

3. SOC-Berechnungsverfahren nach Anspruch 1, wobei der Entladungsparameter einen Entladungsstrom umfasst; und
das Berechnen eines SOC-Korrekturkoeffizienten anhand der ersten Spannungsdifferenz und des Entladungsparameters Folgendes umfasst:
Berechnen einer Stromdifferenz zwischen dem Entladungsstrom und einem Referenzstrom; und
Berechnen des SOC-Korrekturkoeffizienten anhand der Stromdifferenz und der ersten Spannungsdifferenz.

4. SOC-Berechnungsverfahren nach Anspruch 3, wobei das Berechnen des SOC-Korrekturkoeffizienten anhand der Stromdifferenz und der ersten Spannungsdifferenz Folgendes umfasst:
Berechnen des SOC-Korrekturkoeffizienten durch Verwendung der folgenden Formel: $K = 1 + a \times \left(i-{i}_{ref}\right) \times \left({v}_{ref}-v\right)$
wobei K den SOC-Korrekturkoeffizienten angibt, a eine voreingestellte Konstante größer als Null und kleiner als 1 angibt, i den Entladungsstrom angibt, i_{ref} den Referenzstrom angibt, v_{ref} die voreingestellte Spannung angibt und v die Batteriekernspannung angibt.

5. SOC-Berechnungsverfahren nach Anspruch 1, wobei das Verfahren ferner Folgendes umfasst: Aktualisieren des Korrekturkoeffizienten auf 1, wenn die Batteriekernspannung größer als die voreingestellte Spannung ist oder wenn sich das Batteriemodul nicht in dem Entladezustand befindet.

6. SOC-Berechnungsverfahren nach Anspruch 1, wobei der Entladungsparameter einen Widerstandswert einer Last umfasst; und
das Berechnen eines SOC-Korrekturkoeffizienten anhand der ersten Spannungsdifferenz und des Entladungsparameters Folgendes umfasst:
Berechnen einer Widerstandsdifferenz zwischen dem Widerstandswert der Last und einem voreingestellten Widerstandswert, wenn der Widerstandswert der Last größer als der voreingestellte Widerstandswert ist; und
Berechnen des SOC-Korrekturkoeffizienten anhand der Widerstandsdifferenz und der ersten Spannungsdifferenz.

7. SOC-Berechnungsverfahren nach einem der Ansprüche 1 bis 5, wobei das Verfahren vor dem Schritt zum Berechnen eines SOC-Korrekturkoeffizienten anhand der ersten Spannungsdifferenz und des Entladungsparameters ferner Folgendes umfasst:
Bestimmen, ob der Batteriestand des Batteriemoduls kleiner oder gleich einem voreingestellten Batteriestand ist; und
Durchführen des Schritts zum Berechnen eines SOC-Korrekturkoeffizienten anhand der ersten Spannungsdifferenz und des Entladungsparameters, wenn der Batteriestand des Batteriemoduls kleiner oder gleich dem voreingestellten Batteriestand ist.

8. SOC-Berechnungsverfahren nach einem der Ansprüche 1 bis 6, wobei der Schritt zum Berechnen eines SOC-Werts anhand der Nennvollastkapazität des Batteriemoduls, des Entladungsparameters und des Korrekturkoeffizienten Folgendes umfasst:
Berechnen des SOC-Werts durch Verwendung der folgenden Formel: $SOC = \left(fullcap-K*\int Idt\right) / fullcap$
wobei *"fullcap*" die Nennvollastkapazität des Batteriemoduls angibt, ∫*Idt* die Entladungskapazität des Batteriemoduls angibt und *K* den Korrekturkoeffizienten angibt.

9. Steuerschaltung (300), umfassend einen Prozessor (302), einen Speicher (303) und einen Datenbus (301), der so konfiguriert ist, dass er eine Verbindung und Kommunikation zwischen dem Prozessor und dem Speicher implementiert, wobei der Speicher ein Computerprogramm speichert, das von dem Prozessor ausführbar ist, und das Computerprogramm, wenn es von dem Prozessor ausgeführt wird, die Schritte des SOC-Berechnungsverfahrens nach einem der Ansprüche 1 bis 8 implementiert.

10. Elektronische Vorrichtung (400), umfassend:
ein Batteriemodul (401);
einen oder mehrere Prozessoren (302, 402); und
eine Speichervorrichtung (303, 402), die so konfiguriert ist, dass sie eines oder mehrere Programme speichert, wobei das eine oder mehrere Programme, wenn sie von dem einen oder mehreren Prozessoren ausgeführt werden, bewirken, dass die elektronische Vorrichtung das SOC-Berechnungsverfahren nach einem der Ansprüche 1 bis 8 implementiert.

## Revendications

1. Procédé de calcul de l'état de charge pour un module de batterie, comprenant :
l'obtention (S101, S201)
d'une tension de noyau de batterie d'un module de batterie dans un état de décharge ;
l'obtention (S102, S202)
d'un paramètre de décharge du module de batterie lorsque la tension de noyau de batterie est inférieure ou égale à une tension prédéfinie, laquelle tension prédéfinie est supérieure à une tension de protection contre la sous-tension d'un module de batterie ;
l'obtention (S103, S203)
d'une première différence de tension entre la tension prédéfinie et la tension de noyau de batterie ;
**caractérisé par** le calcul (S104, S205)
d'un coefficient de correction d'un état de charge selon la première différence de tension et le paramètre de décharge, lequel coefficient de correction est positivement corrélé au paramètre de décharge et inversement corrélé à la tension de noyau de batterie ; et
le calcul (S105, S206)
d'une valeur de l'état de charge selon une capacité nominale à pleine charge du module de batterie, le paramètre de décharge et le coefficient de correction.

2. Procédé de calcul de l'état de charge selon la revendication 1, dans lequel l'étape d'obtention d'une tension de noyau de batterie d'un module de batterie dans un état de décharge comprend :
l'acquisition de la tension de noyau de batterie du module de batterie à une première fréquence d'échantillonnage lorsque la tension de noyau de batterie est supérieure à la tension prédéfinie ; et
l'acquisition de la tension de noyau de batterie du module de batterie à une seconde fréquence d'échantillonnage lorsque la tension de noyau de batterie est inférieure ou égale à la tension prédéfinie, dans laquelle la seconde fréquence d'échantillonnage est supérieure à la première fréquence d'échantillonnage.

3. Procédé de calcul de l'état de charge selon la revendication 1, dans lequel le paramètre de décharge comprend un courant de décharge ; et
le calcul d'un coefficient de correction d'un état de charge selon la première différence de tension et le paramètre de décharge comprend :
le calcul d'une différence de courant entre le courant de décharge et un courant de référence ; et
le calcul du coefficient de correction de l'état de charge selon la différence de courant et la première différence de tension.

4. Procédé de calcul de l'état de charge selon la revendication 3, dans lequel le calcul du coefficient de correction de l'état de charge selon la différence de courant et la première différence de tension comprend :
le calcul du coefficient de correction de l'état de charge en utilisant la formule suivante : $K = 1 + a \times \left(i-{i}_{re}f\right) \times \left({v}_{re}f-v\right)$
dans lequel K indique le coefficient de correction de l'état de charge, a indique une constante prédéfinie supérieure à zéro et inférieure à 1, i indique le courant de décharge, iᵣₑf indique le courant de référence, vᵣₑf indique la tension prédéfinie, et v indique la tension de noyau de batterie.

5. Procédé de calcul de l'état de charge selon la revendication 1, dans lequel le procédé comprend en outre : la mise à jour du coefficient de correction à 1 lorsque la tension de noyau de batterie est supérieure à la tension prédéfinie ou lorsque le module de batterie n'est pas dans l'état de décharge.

6. Procédé de calcul de l'état de charge selon la revendication 1, dans lequel le paramètre de décharge comprend une valeur de résistance d'une charge ; et
le calcul d'un coefficient de correction d'un état de charge selon la première différence de tension et le paramètre de décharge comprend :
le calcul d'une différence de résistance entre la valeur de résistance de la charge et une valeur de résistance prédéfinie lorsque la valeur de résistance de la charge est supérieure à la valeur de résistance prédéfinie ; et
le calcul du coefficient de correction de l'état de charge selon la différence de résistance et la première différence de tension.

7. Procédé de calcul de l'état de charge selon l'une quelconque des revendications 1 à 5, dans lequel, avant l'étape de calcul d'un coefficient de correction d'un état de charge selon la première différence de tension et le paramètre de décharge, le procédé comprend en outre :
la détermination si un niveau de batterie du module de batterie est inférieur ou égal à un niveau de batterie prédéfini ; et
l'exécution de l'étape de calcul d'un coefficient de correction d'un état de charge selon la première différence de tension et le paramètre de décharge si le niveau de batterie du module de batterie est inférieur ou égal au niveau de batterie prédéfini.

8. Procédé de calcul de l'état de charge selon l'une quelconque des revendications 1 à 6, dans lequel l'étape de calcul d'une valeur de l'état de charge selon une capacité nominale à pleine charge du module de batterie, le paramètre de décharge et le coefficient de correction comprend :
le calcul de la valeur de l'état de charge en utilisant la formule suivante : $état de charge = \left(fullcap-K*\int Idt\right) / fullcap$
dans lequel fullcap indique la capacité nominale à pleine charge du module de batterie, ∫Idt indique une capacité de décharge du module de batterie, et K indique le coefficient de correction.

9. Circuit de commande (300), comprenant un processeur (302), une mémoire (303), et un bus de données (301) configuré
pour permettre la connexion et la communication entre le processeur et la mémoire, dans lequel la mémoire stocke un programme informatique exécutable par le processeur, et le programme informatique, lorsqu'il est exécuté par le processeur, met en œuvre les étapes du procédé de calcul de l'état de charge selon l'une quelconque des revendications 1 à 8.

10. Dispositif électronique (400), comprenant :
un module de batterie (401) ;
un ou plusieurs processeurs (302, 402) ; et
un dispositif de stockage (303, 402),
configuré pour stocker un ou plusieurs programmes, lesquels un ou plusieurs programmes, lorsqu'ils sont exécutés par le ou les processeurs, amènent le dispositif électronique à mettre en œuvre le procédé de calcul de l'état de charge selon l'une quelconque des revendications 1 à 8.
